# EUROPÄISCHE PATENTANMELDUNG

(11) **EP 3 322 088 A1**
(43) Veröffentlichungstag der Anmeldung: **16.05.2018**
(21) Anmeldenummer: 16198136.0
(22) Anmeldetag: 10.11.2016
(51) Int. Cl.: H02P 29/02, G01R 31/34, H02P 23/14

(54) **VERFAHREN ZUM ÜBERWACHEN DES BETRIEBES EINER ELEKTRISCHEN ROTIERENDEN MASCHINE**

(71) Anmelder: Siemens Aktiengesellschaft, 80333 München (DE)
(72) Erfinder: Anders, Peter, 91052 Erlangen (DE); Hain, Stefan, 91090 Effeltrich (DE)

(57) **Zusammenfassung**

Verfahren zum Überwachen des Betriebes einer elektrischen rotierenden Maschine (2) mit einem Rotor (8), einem Stator (10) und einem Maschinengehäuse (18), in dem der Rotor (8) und der Stator (10) aufgenommen sind. Um eine Durchführung des Verfahrens ohne konstruktive Änderungen an der elektrischen rotierenden Maschine (2) zu ermöglichen, wird vorgeschlagen, dass außerhalb des Maschinengehäuses (18) eine erste physikalische Größe des Stators (10) und eine zweite physikalische Größe des Rotors (8) gemessen wird, wobei aus der ersten physikalischen Größe und der zweiten physikalischen Größe mindestens eine Zustandsgröße der elektrischen rotierenden Maschine (2) ermittelt wird.

## Beschreibung

Die Erfindung betrifft ein Verfahren zum Überwachen des Betriebes einer elektrischen rotierenden Maschine mit einem Rotor, einem Stator und einem Maschinengehäuse, in dem der Rotor und der Stator aufgenommen sind.

Darüber hinaus betrifft die Erfindung ein Sensorsystem für eine elektrische rotierende Maschine.

Ferner betrifft die Erfindung eine elektrische rotierende Maschine mit einem Rotor, einem Stator, einem Maschinengehäuse, in das der Rotor und der Stator aufgenommen sind, und mindestens ein derartiges Sensorsystem.

Bei der Überwachung des Betriebes einer elektrischen rotierenden Maschine werden Zustandsgrößen, beispielsweise ein abgegebenes Drehmoment, eine abgegebene mechanische Leistung oder ein Energieverbrauch, in bestimmten Intervallen überprüft, um Wartungsintervalle zu koordinieren oder bei Bedarf frühzeitig Gegenmaßnahmen einzuleiten. Eine elektrische rotierende Maschine ist beispielsweise ein Motor oder ein Generator. Die Ermittlung derartiger Zustandsgrößen erfordert einen hohen messtechnischen Aufwand, insbesondere wenn die elektrische rotierende Maschine ohne einen Frequenzumrichter oder ein Motormanagement- und/oder Steuergerät betrieben wird.

Zur Ermittlung eines abgegebenen Drehmoments wird beispielsweise ein spezieller Drehmomentsensor an einer Welle der elektrischen rotierenden Maschine montiert. Die Patentschrift EP 0 974 822 B1 beschreibt einen Drehmomentsensor mit einem ersten Signalgeber, dessen Ausgangssignal sich in Abhängigkeit von einem Drehmoment ändert, einem zweiten Signalgeber, dessen Ausgangssignal sich in Abhängigkeit von dem Drehmoment gegenläufig ändert, und einer Auswerteeinrichtung, die eine Summiereinrichtung aufweist, die mit den beiden Signalgebern verbunden ist.

Alternativ wird der Motorstrom mittels Stromwandlern gemessen und mit Hilfe einer geeigneten Auswerteelektronik in seine Wirk- und Scheinanteile zerlegt. Die Patentschrift
EP 0 800 265 B1 beschreibt ein Verfahren zur direkten Drehmomentregelung einer Drehfeldmaschine mit einem mehrphasigen Umrichter, wobei ein Fluss-Istwert aus einer Umrichterspannung und einer Korrekturgröße berechnet wird und wobei Drehmoment-Istwerte aus einem vom Umrichter abgegebenen Strom und dem Fluss-Istwert berechnet wird.

Die Patentschrift DE 44 02 152 C1 beschreibt ein Schleuderschutzverfahren für mit Asynchronmotoren angetriebene Fahrzeuge, wobei das Verfahren darauf basiert, dass aus einer zeitlichen Änderung einer mechanischen Frequenz und einer Rotorfrequenz ein Quotient gebildet wird. Anhand dieses Quotienten wird eine Regelgröße, mittels welcher das Drehmoment bzw. die Zugkraft eingestellt werden kann, beeinflusst.

Die Patentschrift EP 2 300 793 B1 beschreibt eine Anordnung mit einer elektrischen Maschine, die einen Stator und einen Rotor aufweist, sowie mit einem Infrarot-Temperatursensor zur kontaktlosen Temperaturmessung. Um eine verbesserte Überwachung der Temperatur des Rotors zu ermöglichen, ist dabei das Detektionsfeld des Infrarot-Temperatursensors durch eine, konstruktionsbedingt üblicherweise vorhandene oder eine speziell für die Infrarot-Temperaturmessung vorgesehene, Öffnung des Stators auf die Mantelfläche des Rotors ausgerichtet.

Der Erfindung liegt die Aufgabe zugrunde, ein Verfahren zum Überwachen des Betriebes einer elektrischen rotierenden Maschine bereitzustellen, dessen Durchführung ohne konstruktive Änderungen an der elektrischen rotierenden Maschine möglich ist.

Die Aufgabe wird erfindungsgemäß durch ein Verfahren zum Überwachen des Betriebes einer elektrischen rotierenden Maschine mit einem Rotor, einem Stator und einem Maschinengehäuse, in dem der Rotor und der Stator aufgenommen sind, gelöst, wobei außerhalb des Maschinengehäuses eine erste physikalische Größe des Stators und eine zweite physikalische Größe des Rotors gemessen wird und wobei aus der ersten physikalischen Größe und der zweiten physikalischen Größe mindestens eine Zustandsgröße der elektrischen rotierenden Maschine ermittelt wird.

Ferner wird die Aufgabe erfindungsgemäß durch ein Sensorsystem für eine elektrische rotierende Maschine mit mindestens einem ersten Sensor, mindestens einem zweiten Sensor und einer Auswerteeinrichtung gelöst, wobei der mindestens eine erste Sensor zur Messung einer ersten physikalischen Größe eines Stators der elektrischen rotierenden Maschine außerhalb eines Maschinengehäuses der elektrischen rotierenden Maschine vorgesehen ist, der mindestens eine zweite Sensor zur Messung einer zweiten physikalischen Größe eines Rotors der elektrischen rotierenden Maschine außerhalb des Maschinengehäuses der elektrischen rotierenden Maschine vorgesehen ist und die Auswerteeinrichtung dafür vorgesehen ist, mit der ersten physikalischen Größe und der zweiten physikalischen Größe mindestens eine Zustandsgröße der elektrischen rotierenden Maschine zu ermitteln.

Darüber hinaus wird die Aufgabe erfindungsgemäß durch eine elektrische rotierende Maschine mit einem Rotor, einem Stator, einem Maschinengehäuse, in das der Rotor und der Stator aufgenommen sind, und mindestens einem derartigen Sensorsystem gelöst, wobei das Sensorsystem außerhalb des Maschinengehäuses angeordnet ist.

Die in Bezug auf das Verfahren nachstehend angeführten Vorteile und bevorzugten Ausgestaltungen lassen sich sinngemäß auf das Sensorsystem und die elektrische rotierende Maschine übertragen.

Der Erfindung liegt die Überlegung zugrunde, jeweils mindestens eine physikalische Größen eines Stators und eines Rotors einer elektrischen rotierenden Maschine, wie beispielsweise ein Magnetfeld, eine Schwingung und/oder eine Vibration, außerhalb eines Maschinengehäuses der elektrischen rotierenden Maschine zu messen, um aus den physikalischen Größen eine Zustandsgröße für eine Überwachung der elektrischen rotierenden Maschine, beispielsweise ein abgegebenes Drehmoment, eine abgegebene mechanischen Leistung oder einen Leistungsverbrauch, abzuleiten. Insbesondere werden die physikalischen Größen kontaktlos, das heißt ohne direkten Kontakt zum Stator und zum Rotor der elektrischen rotierenden Maschine gemessen. Der Vorteil der, insbesondere kontaktlosen, Messung außerhalb des Maschinengehäuses ist, dass keine konstruktiven Änderungen erforderlich sind. Daher wird die elektrische rotierende Maschine durch das Verfahren nicht in ihrem Betrieb beeinflusst und die Mittel zur Durchführung des Verfahrens sind leicht nachrüstbar.

In einer vorteilhaften Ausgestaltung wird als erste physikalische Größe ein elektromagnetisches Feld des Stators gemessen. Beispielsweise wird ein äußeres Stator-Streufeld mit Hilfe eines Magnetfeldsensors, der an einer Außenseite des Maschinengehäuses angebracht ist, gemessen. Der Magnetfeldsensor ist beispielswiese als ein Hall-Sensor, GMR-Sensor, TMR-Sensoren oder AMR-Sensor ausgeführt. Das Stator-Streufeld ist auch außerhalb des Maschinengehäuses noch groß genug für eine zuverlässige und schnelle Messung. Ein weiterer Vorteil ist, dass die Messung des elektromagnetischen Feldes, insbesondere des äußeren Streufeldes, des Stators nicht-invasiv, das heißt ohne konstruktive Änderungen an der elektrischen rotierenden Maschine erfolgt.

In besonders vorteilhafter Weise wird aus dem elektromagnetischen Feld eine Statorfrequenz ermittelt. Insbesondere wird aus einer zeitlichen Änderung des Statorfeldes eine Statorfrequenz ermittelt. Insbesondere bei netzgespeisten Motoren ist die Statorfrequenz konstant und abhängig von der Polpaarzahl und von der Netzfrequenz, wobei die Netzfrequenz beispielsweise bei 50 Hz oder 60 Hz liegt. Beispielsweise werden netzbedingte Schwankungen, die beispielsweise im Bereich bis 0,2 Hz liegen, bei der Ermittlung der Zustandsgröße unter Berücksichtigung der Statorfrequenz mit einbezogen. Eine Ermittlung der Statorfrequenz aus dem elektromagnetischen Feld des Stators ist schnell und zuverlässig.

Bei einer weiteren vorteilhaften Ausführungsform wird als zweite physikalische Größe ein Schwingungsverhalten des Rotors gemessen. Insbesondere wird das Schwingungsverhalten des Rotors mittels eines Beschleunigungssensors oder einen, insbesondere optischen, Vibrationssensor ermittelt, der zusammen mit dem Magnetfeldsensor an der Außenseite des Maschinengehäuses angebracht ist. Eine Messung des Rotor-Schwingungsverhaltens ist auch außerhalb des Maschinengehäuses und ohne konstruktive Änderungen an der elektrischen rotierenden Maschine zuverlässig und schnell.

Vorteilhaft wird aus dem Schwingungsverhalten eine Rotorfrequenz ermittelt. Insbesondere wird aus periodischen Anteilen eines Schwingungssignals, die beispielsweise durch eine leichte Unwucht des Rotors entstehen, die Rotorfrequenz berechnet. Eine Ermittlung der Rotorfrequenz aus dem Schwingungsverhalten des Rotors ist selbst bei, insbesondere mechanischen, Störungen zuverlässig.

In vorteilhafter Weise wird die Rotorfrequenz mit einer FFT und/oder mit einem Frequenzzählverfahren ermittelt. Unter einer FFT versteht man eine Fast Fourier Transformation, mit deren Hilfe das gemessene Schwingungssignal in den Frequenzbereich transformiert wird. Die Darstellung der insbesondere näherungsweise konstanten Rotorfrequenz erfolgt nach der FFT in Form einer Spektrallinie im Frequenzbereich. Durch die Verwendung einer FFT lässt sich die Rotorfrequenz im Frequenzbereich mit hoher Genauigkeit ermitteln. Bei einem Frequenzzählverfahren, welches insbesondere nach einer Filterung durchgeführt wird, wird eine Frequenz eines insbesondere periodischen Signals, durch Zählen, beispielsweise von Nulldurchgängen, ermittelt. Durch das Frequenzzählverfahren wird eine Frequenz energieeffizient ermittelt.

Vorteilhafterweise wird aus der Statorfrequenz und der Rotorfrequenz eine Schlupffrequenz ermittelt. Insbesondere ist die Schlupffrequenz bei einer Asynchronmaschine die Abweichung der Rotorfrequenz von der Statorfrequenz. Aus der Schlupffrequenz lassen sich mehrere Zustandsgrößen ermitteln.

In besonders vorteilhafter Weise wird aus der Schlupffrequenz die mindestens eine Zustandsgröße der elektrischen rotierenden Maschine, insbesondere ein Drehmoment und/oder eine abgegebene mechanische Leistung der elektrischen rotierenden Maschine, ermittelt. Insbesondere ein abgegebenes Drehmoment ist in einem betrachteten Arbeitsbereich näherungsweise proportional zum Schlupf, wobei die abgegebene mechanische Leistung der elektrischen rotierenden Maschine beispielsweise aus dem abgegebenen Drehmoment berechnet wird. Mit Hilfe der durch nicht-invasive Messungen ermittelten Schlupffrequenz werden Zustandsgrößen der elektrischen rotierenden Maschine ohne konstruktive Änderungen mit ausreichender Genauigkeit ermittelt.

Ausführungsbeispiele der Erfindung werden anhand von Zeichnungen näher erläutert. Hierin zeigen stark vereinfacht:
- FIG 1: einen Längsschnitt einer elektrischen rotierenden Maschine mit einer ersten Ausführungsform eines Sensorsystems und
- FIG 2: einen Längsschnitt einer elektrischen rotierenden Maschine mit einer zweiten Ausführungsform eines Sensorsystems.

Gleiche Bezugszeichen haben in den verschiedenen Figuren die gleiche Bedeutung.

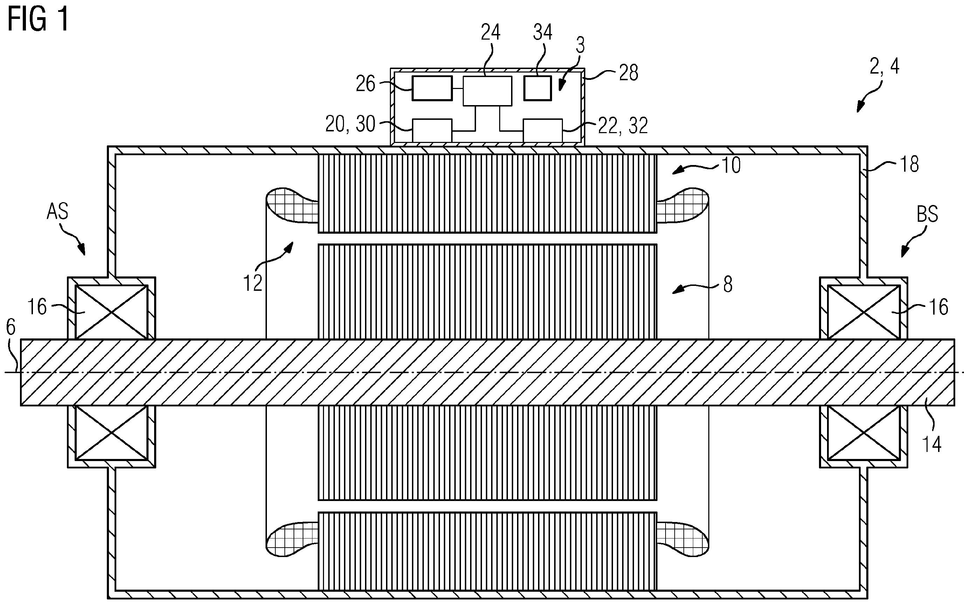

FIG 1 zeigt einen Längsschnitt einer elektrischen rotierenden Maschine 2 mit einer ersten Ausführungsform eines Sensorsystems 3. Die elektrische rotierende Maschine 2 ist als Asynchronmaschine 4 ausgeführt und weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12 befindet. Der Rotor 8 weist eine Welle 14 auf, die über jeweils mindestens ein Lager 16 an einer Antriebsseite AS und an einer Nicht-Antriebsseite BS der elektrischen rotierenden Maschine 2 gelagert ist. Der Rotor 8 und der Stator 10 sind in einem geschlossenen Maschinengehäuse 18 untergebracht.

Das Sensorsystem 3 umfasst mindestens einen ersten Sensor 20, mindestens einen zweiten Sensor 22, eine Auswerteeinrichtung 24 und eine Ausgabeeinheit 26. Die Sensoren 20, 22, die Auswerteeinrichtung 24 und die Ausgabeeinheit 26 befinden sich in einem geschlossenen Sensorvorrichtungsgehäuse 28. Das Sensorvorrichtungsgehäuse 28 liegt auf der Oberfläche des geschlossenen Maschinengehäuses 18 auf und ist beispielsweise über Verbindungselemente, insbesondere Schrauben oder Magnete, lösbar mit dem Maschinengehäuse 18 verbunden. Insbesondere bei der Verwendung von Magneten als Verbindungselemente kann das Sensorsystem bei älteren elektrischen rotierenden Maschinen 2 nachgerüstet werden.

Der mindestens eine erste Sensor 20 ist als ein Magnetfeldsensor 30 ausgeführt, wobei während des Betriebes der elektrischen rotierenden Maschine 2 von dem Magnetfeldsensor 30 ein äußeres Streufeld des Stators 10 gemessen wird, aus dessen, insbesondere periodischer, zeitlicher Änderung eine Statorfrequenz ermittelt wird. Der mindestens eine zweite Sensor 22 ist als ein Beschleunigungssensor 32 ausgeführt, der ein Schwingungsverhalten des Rotors 8 erfasst. Mit Hilfe einer Fast Fourier Transformation, kurz FFT, wird das vom Beschleunigungssensor 32 erfasste Schwingungssignal in den Frequenzbereich transformiert und anschließend aus dem ermittelten Spektrum des Schwingungssignals die mechanische Rotorfrequenz ermittelt. Eine Schlupffrequenz der Asynchronmaschine 4 wird aus der mechanischen Rotorfrequenz und der Statorfrequenz berechnet.

Aus der Schlupffrequenz und zusätzlichen, insbesondere typenspezifischen, Kennwerten der Asynchronmaschine 4 werden Zustandsgrößen der Asynchronmaschine 4 berechnet. Die Kennwerte sind beispielsweise in einem Datenblatt und/oder einem Typenschild zu finden und beinhalten beispielsweise eine Polpaarzahl, eine Nenndrehzahl, eine mechanisch abgegebene Nennleistung und einen Wirkungsgrad.

Im betrachteten Arbeitsbereich vom Leerlauf bis zum ungefähr halben Kippmoment und/oder bis zum ungefähr 1,5-fachen Nenndrehmoment verhält sich die Schlupffrequenz näherungsweise linear und proportional zum von der elektrischen rotierenden Maschine 2 abgegebenen Drehmoment. Daher wird das abgegebene Drehmoment mit guter Genauigkeit im betrachteten Arbeitsbereich aus der Schlupffrequenz der Asynchronmaschine 4 ermittelt. Aus dem abgegebenen Drehmoment wird die abgegebene mechanische Leistung berechnet. Die aufgenommene elektrische Leistung wird näherungsweise aus der abgegebenen mechanischen Leistung und dem Wirkungsgrad berechnet, wobei der Wirkungsgrad im betrachteten Arbeitsbereich als konstant angenommen wird. Über eine zeitliche Integration wird die aufgenommene elektrische Energie ermittelt.

Zumindest eine berechnete Zustandsgröße der elektrischen rotierenden Maschine 2 wird über eine Ausgabeeinheit 26 ausgegeben. Eine derartige Ausgabeeinheit 26 ist beispielsweise ein Display, ein Lautsprecher oder ein anderes visuelles und/oder akustisches Ausgabemedium. Zusätzlich oder alternativ weist die Ausgabeeinheit 26 Mittel zur Übertragung der ermittelten Daten an ein Computersystem und/oder an ein Cloud-basiertes oder virtualisiertes Datenbanksystem auf. Die Datenübertragung findet drahtlos, drahtgebunden oder optisch statt. Beispielswiese findet die Datenübertragung über Bluetooth oder WLAN statt. Darüber hinaus umfasst das Sensorsystem 3 eine Steuervorrichtung 34, die beispielswiese den, insbesondere zeitlichen, Ablauf der Messung und Auswertung steuert.

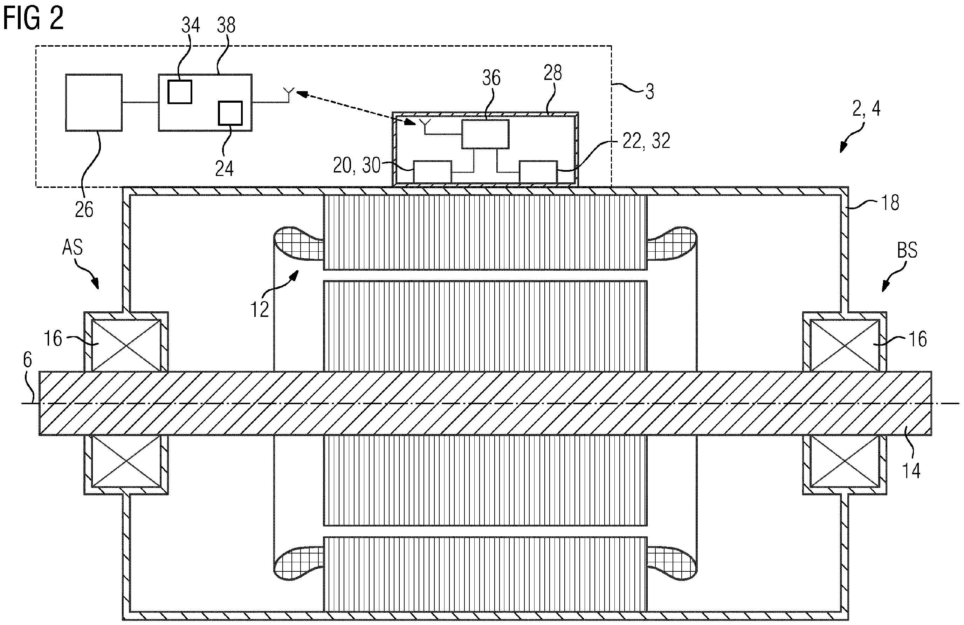

FIG 2 zeigt einen Längsschnitt einer elektrischen rotierenden Maschine 2 mit einer zweiten Ausführungsform eines Sensorsystems 3. Die Sensoren 20, 22 sind mit einer Kommunikationseinheit 36 verbunden, die die von den Sensoren 20, 22 gemessenen Sensorsignale, insbesondere drahtlos, an eine Basisstation 38 übertragen. In der Basisstation 38 werden mit Hilfe einer Auswerteeinrichtung 24 die Sensorsignale kombiniert und die Zustandsgrößen der elektrischen rotierenden Maschinen 2, wie in FIG 1 beschrieben, ermittelt. Ferner weist die Basisstation 38 eine Steuervorrichtung 34 zur, insbesondere zeitlichen, Steuerung des Ablaufs der Messung, der Übertragung und der Auswertung auf. Die ermittelten Zustandsgrößen der elektrischen rotierenden Maschine 2 werden an eine Ausgabeeinheit 26 übertragen, die als ein visuelles und/oder akustisches Ausgabemedium, ausgeführt ist. Zusätzlich oder alternativ weist die Ausgabeeinheit 26 Mittel zur Übertragung der ermittelten Daten an ein Computersystem und/oder an ein Cloud-basiertes oder virtualisiertes Datenbanksystem auf. Die Datenübertragung findet drahtlos, drahtgebunden oder optisch statt. Beispielswiese findet die Datenübertragung über Bluetooth oder WLAN statt. Die weitere Ausführung der elektrischen rotierenden Maschine 2 und des Sensorsystems 3 entspricht der in FIG 1.

## Patentansprüche

1. Verfahren zum Überwachen des Betriebes einer elektrischen rotierenden Maschine (2) mit einem Rotor (8), einem Stator (10) und einem Maschinengehäuse (18), in dem der Rotor (8) und der Stator (10) aufgenommen sind,
wobei außerhalb des Maschinengehäuses (18) eine erste physikalische Größe des Stators (10) und eine zweite physikalische Größe des Rotors (8) gemessen wird und
wobei aus der ersten physikalischen Größe und der zweiten physikalischen Größe mindestens eine Zustandsgröße der elektrischen rotierenden Maschine (2) ermittelt wird.

2. Verfahren nach Anspruch 1,
wobei als erste physikalische Größe ein elektromagnetisches Feld des Stators (10) gemessen wird.

3. Verfahren nach einem der Ansprüche 1 oder 2,
wobei aus dem elektromagnetischen Feld eine Statorfrequenz ermittelt wird.

4. Verfahren nach einem der vorherigen Ansprüche,
wobei als zweite physikalische Größe ein Schwingungsverhalten des Rotors (8) gemessen wird.

5. Verfahren nach Anspruch 4,
wobei aus dem Schwingungsverhalten eine Rotorfrequenz ermittelt wird.

6. Verfahren nach Anspruch 5,
wobei die Rotorfrequenz mit einer FFT und/oder mit einem Frequenzzählverfahren ermittelt wird.

7. Verfahren nach Anspruch 3 und einem der Ansprüche 5 oder 6,
wobei aus der Statorfrequenz und der Rotorfrequenz eine Schlupffrequenz ermittelt wird.

8. Verfahren nach Anspruch 7,
wobei aus der Schlupffrequenz die mindestens eine Zustandsgröße der elektrischen rotierenden Maschine (2), insbesondere ein Drehmoment und/oder eine abgegebene mechanische Leistung der elektrischen rotierenden Maschine (2), ermittelt wird.

9. Sensorsystem (3) für eine elektrische rotierende Maschine (2) mit mindestens einem ersten Sensor (20), mindestens einem zweiten Sensor (22) und einer Auswerteeinrichtung (24), wobei
- der mindestens eine erste Sensor (20) zur Messung einer ersten physikalischen Größe eines Stators (10) der elektrischen rotierenden Maschine (2) außerhalb eines Maschinengehäuses (18) der elektrischen rotierenden Maschine (2) vorgesehen ist,
- der mindestens eine zweite Sensor (22) zur Messung einer zweiten physikalischen Größe eines Rotors (8) der elektrischen rotierenden Maschine (2) außerhalb des Maschinengehäuses (18) der elektrischen rotierenden Maschine (2) vorgesehen ist und
- die Auswerteeinrichtung (24) dafür vorgesehen ist, mit der ersten physikalischen Größe und der zweiten physikalischen Größe mindestens eine Zustandsgröße der elektrischen rotierenden Maschine (2) zu ermitteln.

10. Sensorsystem (3) nach Anspruch 9,
wobei der mindestens eine erste Sensor (20) als ein Magnetfeldsensor (30) ausgeführt ist.

11. Sensorsystem (3) nach einem der Ansprüche 9 oder 10, wobei der mindestens eine zweite Sensor (22) als ein Beschleunigungssensor (32) ausgeführt ist.

12. Sensorsystem (3) nach einem der Ansprüche 9 bis 11,
welches ein geschlossenes Sensorvorrichtungsgehäuse (24) aufweist, in das die Sensoren (20, 22) aufgenommen sind.

13. Sensorsystem (3) nach einem der Ansprüche 9 bis 12, welches eine Steuervorrichtung (34) aufweist.

14. Elektrische rotierende Maschine (2) mit einem Rotor (8), einem Stator (10), einem Maschinengehäuse (18), in das der Rotor (8) und der Stator (10) aufgenommen sind, und mindestens einem Sensorsystem (3) nach einem der Ansprüche 9 bis 13,
wobei das Sensorsystem (3) außerhalb des Maschinengehäuses (18) angeordnet ist.

15. Elektrische rotierende Maschine (2) nach Anspruch 13, wobei das Sensorsystem (3) auf dem Maschinengehäuses (18) aufliegt.
